(19)

Europäisches
Patentamt
European
Patent Office
Office européen
des brevets

(11) **EP 4 307 562 A1**

(12) **EUROPEAN PATENT APPLICATION**

(43) Date of publication:
    **17.01.2024 Bulletin 2024/03**

(51) International Patent Classification (IPC):
    **H03F 1/02** *(2006.01)*        **H03F 1/32** *(2006.01)*
    **H03F 1/56** *(2006.01)*        **H03F 3/195** *(2006.01)*
    **H03F 3/213** *(2006.01)*       **H03H 11/48** *(2006.01)*

(21) Application number: **22184775.9**

(22) Date of filing: **13.07.2022**

(52) Cooperative Patent Classification (CPC):
    **H03F 1/0266; H03F 1/3241; H03F 1/56;**
    **H03F 3/195; H03F 3/213;** H03F 2200/213;
    H03F 2200/222; H03F 2200/451; H03H 11/48

(84) Designated Contracting States:
    **AL AT BE BG CH CY CZ DE DK EE ES FI FR GB**
    **GR HR HU IE IS IT LI LT LU LV MC MK MT NL NO**
    **PL PT RO RS SE SI SK SM TR**
    Designated Extension States:
    **BA ME**
    Designated Validation States:
    **KH MA MD TN**

(71) Applicant: **NXP USA, Inc.**
    **Austin TX 78735 (US)**

(72) Inventors:
    • **DE JONG, Gerben Willem**
      **5656 AG Eindhoven (NL)**

    • **BERGERVOET, Jozef Reinerus Maria**
      **5656 AG Eindhoven (NL)**
    • **VAN DER HEIJDEN, Mark Peter**
      **5656 AG Eindhoven (NL)**

(74) Representative: **Miles, John Richard**
    **NXP SEMICONDUCTORS**
    **Intellectual Property Group**
    **Abbey House**
    **25 Clarendon Road**
    **Redhill, Surrey RH1 1QZ (GB)**

Remarks:
    Amended claims in accordance with Rule 137(2)
    EPC.

(54) **ANALOG AMPLITUDE PRE-DISTORTION CIRCUIT AND METHOD**

(57)    An analog amplitude pre-distortion circuit and method. The circuit includes an RF input for receiving an RF signal. The circuit also includes an amplifier stage comprising an amplifier stage input coupled to the RF input, wherein the amplifier stage is operable to amplify the RF signal to produce an amplified RF signal. The circuit further includes a bias circuit. The bias circuit includes a transistor having a first current terminal, a second current terminal and a control terminal, wherein the first current terminal is coupled to the amplifier stage input and wherein the second current terminal is coupled to a reference potential. The bias circuit also includes a resistor coupled between the amplifier stage input and the control terminal. The bias circuit also includes a variable reactance component coupled to the control terminal. The bias circuit further includes a capacitor coupled between the control terminal and the reference potential.

Fig. 1

## Description

BACKGROUND

The present specification relates to a programmable analog amplitude pre-distortion circuit.

In Wireless Local Area Network (WLAN) Front-End Module (FEM) products, linearity is a key performance parameter, which may, for instance, require error-vector-magnitude (EVM) levels in the order of -47dB and lower (e.g. 802.11ax for WiFi-6(e) and 802.11be for next generation WiFi-7 standards).

SUMMARY

Aspects of the present disclosure are set out in the accompanying independent and dependent claims. Combinations of features from the dependent claims may be combined with features of the independent claims as appropriate and not merely as explicitly set out in the claims.

According to an aspect of the present disclosure, there is provided an analog amplitude pre-distortion circuit comprising:

> a Radio Frequency, RF, input for receiving an RF signal;
> an amplifier stage comprising an amplifier stage input coupled to the RF input for receiving the RF signal, wherein the amplifier stage is operable to amplify the RF signal to produce an amplified RF signal; and
> a bias circuit comprising:
>
>> a transistor having a first current terminal, a second current terminal and a control terminal, wherein the first current terminal is coupled to the amplifier stage input and wherein the second current terminal is coupled to a reference potential;
>> a resistor coupled between the amplifier stage input and the control terminal;
>> a variable reactance component coupled to the control terminal; and
>> a capacitor coupled between the control terminal and the reference potential,
>
> wherein the bias circuit is operable to:
>
>> detect an amplitude of the RF signal;
>> apply a bias voltage at a first range of frequencies according to the amplitude of the RF signal at first impedances to the amplifier stage input; and
>> present second impedances at a second range of frequencies to the amplifier stage input;
>> wherein the first impedances are lower than the second impedances and wherein the first range of frequencies are lower than the second range of frequencies.

The variable reactance component may comprise a variable capacitor.

The variable reactance component may be coupled between the amplifier stage input and the control terminal.

The circuit may further comprise a controller for programmably controlling the variable reactance component.

The circuit may further comprise an output for outputting an amplified RF signal from the amplifier stage.

The circuit may further comprise a current source coupled to the first current terminal.

The transistor of the bias circuit may be a bipolar transistor. The first current terminal may be a collector terminal of the bipolar transistor. The second current terminal may be an emitter terminal of the bipolar transistor. The control terminal may be a base terminal of the bipolar transistor.

The amplifier stage input may comprise a control terminal of a transistor. The transistor may be a bipolar transistor.

The circuit may further comprise a DC-blocking capacitor coupled between the RF input and the amplifier stage input.

According to a further aspect of the present disclosure, there is provided a power amplifier or a low noise amplifier comprising a circuit of the kind set out above.

According to another aspect of the present disclosure, there is provided an analog amplitude pre-distortion method comprising:

> receiving a Radio Frequency, RF, signal;
> using an amplifier stage to amplify the RF signal to produce an amplified RF signal; and
> applying bias voltages to an input of the amplifier stage by:
>
>> detecting an amplitude of the RF signal;
>> applying a bias voltage at a first range of frequencies according to the amplitude of the RF signal at first impedances to the amplifier stage input; and
>> presenting second impedances at a second range of frequencies to the amplifier stage input;
>> wherein the first impedances are lower than the second impedances and wherein the first range of frequencies are lower than the second range of frequencies.

The method may further comprise using a bias circuit to apply the bias voltages to the amplifier stage input. The bias circuit may comprise a transistor having a first current terminal, a second current terminal and a control terminal. The first current terminal may be coupled to an amplifier stage input of the amplifier stage.

The second current terminal may be coupled to a reference potential. The reference potential may, for instance, be ground. The bias circuit may also comprise a resistor and a variable reactance component coupled in parallel between the amplifier stage input and the control terminal. The bias circuit may further comprise a capacitor coupled between the control terminal and the reference potential.

The method may further comprise programmably controlling the variable reactance component to vary the bias voltages applied to the amplifier stage input.

The variable reactance component may be a variable capacitor.

The transistor of the bias circuit may be a bipolar transistor. The first current terminal may be a collector terminal of the bipolar transistor. The second current terminal may be an emitter terminal of the bipolar transistor. The control terminal may be a base terminal of the bipolar transistor.

The amplifier stage input may comprise a control terminal of a transistor. The transistor may be a bipolar transistor.

For the purposes of this application, radio frequency (RF) signals may be considered to be signals in the frequency range $300\,\mathrm{MHz} \leq f \leq 300\,\mathrm{GHz}$. For instance, the RF signals may be in one of the following IEEE bands: C band = 4-8GHz, Ku band = 12-18GHz, Ka band = 26.5-40GHz, UHF, SHF and EHF bands: 300 MHz to 300 GHz.

## BRIEF DESCRIPTION OF THE DRAWINGS

Embodiments of this disclosure will be described hereinafter, by way of example only, with reference to the accompanying drawings in which like reference signs relate to like elements and in which:

Figure 1 shows an analog amplitude pre-distortion circuit according to an embodiment of this disclosure;

Figure 2 shows a Smith Chart for the embodiment of Figure 1;

Figure 3A shows amplitude-amplitude (AM-to-AM) distortion and collector efficiency vs output power for the embodiment of Figure 1; and

Figure 3B shows plots of Error Vector Magnitude (EVM) vs output power for the embodiment of Figure 1.

## DETAILED DESCRIPTION

Embodiments of this disclosure are described in the following with reference to the accompanying drawings.

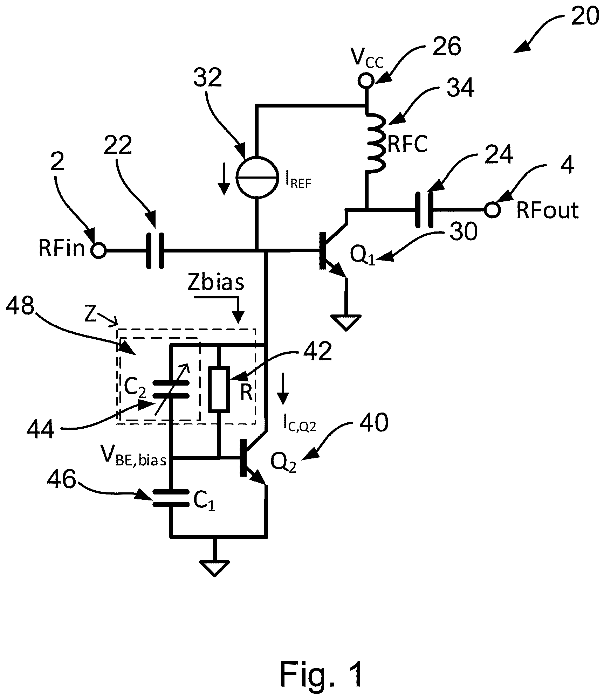

Figure 1 shows an analog amplitude pre-distortion circuit 20 according to an embodiment of this disclosure.

The circuit 20 includes a Radio Frequency (RF), input 2 for receiving an RF signal. The circuit 20 also includes an amplifier stage, which in the present embodiment comprises a transistor 30. The transistor 30 may be a bipolar junction transistor, although it is envisaged that it would be possible to use other kinds of transistor. In this embodiment, a control terminal (e.g. the base terminal) of the transistor 30 is coupled to the input 2 to receive the RF signal from the input 2. A DC-blocking capacitor 22 may be coupled between the control terminal of the transistor 30 and the input 2.

It is envisaged that amplifier stage may be implemented as a basic common emitter (CE) stage using the transistor 30. However, the amplifier stage could also be implemented as a cascode (CE+CB) or a double cascode (CE+CB+CB) stage (where CB refers to a common base stage or transistor).

The circuit 20 may also include an RF output 4 for outputting an amplified RF signal, which corresponds to the RF signal received at the input 2, which has been amplified by the amplifier stage. A DC-blocking capacitor 24 may be coupled between the collector terminal of the transistor 30 and the output 4.

In accordance with an embodiment of this disclosure, the amplification of the RF signal provided by the amplification stage may be made more linear than can be achieved by prior circuits. In particular, the amount of gain expansion or gain compression may be reduced. This may be achieved by the bias circuit, to be described below.

The amplifier stage may also include a current source 32 for supplying a reference current $I_{ref}$. The current source 32 may be coupled to the control terminal of the transistor 30. A supply node 26 for supplying a supply voltage $V_{cc}$ may be coupled to the current source 32 and also to a first current terminal of the transistor 30 (the collector terminal of the transistor 30, in this embodiment). An RF choke 34 may be coupled between the supply node 26 and the aforementioned first current terminal of the transistor 30.

A second current terminal (the emitter terminal in this embodiment) of the transistor 30 may be coupled to a reference voltage, such as ground.

As noted above, the circuit 20 also includes a bias circuit. The bias circuit includes a transistor 40. The transistor may, for instance be a bipolar junction transistor, although it is envisaged that it would be possible to use other kinds of transistor. In this embodiment, a first current terminal (e.g. a collector terminal) of the transistor 40 is coupled to the amplifier stage input (e.g. to the control terminal (e.g. base terminal) of the transistor 30). Note that the first current terminal may thus also be coupled to the input 2. A second current terminal (e.g. an emitter terminal) of the transistor 40 is coupled to a reference voltage, e.g. to ground. The second current terminal of the transistor 40 is also coupled to a control terminal (e.g. base terminal) of the transistor 40 via a capacitor $C_1$.

The transistor 40 is operable to bias the amplifier stage input (the control terminal (e.g. base) of the transistor 30). In the circuit 20, the transistor 40 and the transistor 30 form a current mirror, with $I_{c1\_bias}$ = $\{(Ae_1/Ae_2) \times I_{ref}\}$ in the absence of an RF signal, where $I_{c1\_bias}$ is the current (e.g. collector current) at the first current terminal of the transistor 30, $Ae_1$ is the emitter area of the transistor 30, $Ae_2$ is the emitter area of the transistor 40, and $I_{ref}$ is the reference current provided by the current source 32. The transistor 40 may also operate as an electronic inductor (a gyrator). In particular, the transistor 40 may present a low-ohmic impedance for lower frequencies (in particular for DC and modulation frequencies, and may present a high-ohmic impedance for higher frequencies (in particular at RF frequencies).

The bias circuit also includes at least one variable reactance component 44. In this embodiment, the variable reactance component comprises a variable capacitor ($C_2$). The variable reactance component 44 is coupled between the control terminal (e.g. the base terminal) of the transistor 40 and the first current terminal (e.g. the collector terminal) of the transistor 40.

A resistor 42 may be provided. The resistor 42 may be coupled in parallel with the variable reactance component 44. Accordingly, the resistor 42 may also be coupled between the control terminal (e.g. the base terminal) of the transistor 40 and the first current terminal (e.g. the collector terminal) of the transistor 40. This resistor 42 may act to close the loop around the transistor 40 for DC and modulation frequencies.

The bias circuit is operable to detect an amplitude of the RF signal received at the RF input 2. In this respect, it is noted that to enable the detection of the amplitude, the control terminal (e.g. base terminal) of the transistor 40 is coupled to the RF input 2 via the variable reactance component 44.

The bias circuit is also operable to apply a bias voltage at a first range of frequencies according to the detected amplitude of the RF signal at first impedances to the amplifier stage input (e.g. to the control terminal of the transistor 30). The first range of frequencies may include a generally lower range of frequencies and may include DC (f=0) and modulation frequencies. The first impedances are typically lower impedances.

The bias circuit is further operable to present second impedances at a second range of frequencies to the amplifier stage input (e.g. to the control terminal of the transistor 30). The second range of frequencies may include a generally higher range of frequencies (in particular, higher frequencies than the first range of frequencies). The second range of frequencies may generally correspond to the RF frequencies to be amplified by the amplifier stage.

Moreover, the second impedances are typically higher impedances (in particular higher than the first impedances).

Note that the coupling of the first current terminal (e.g. the collector terminal) of the transistor 40 to the amplifier stage input allows the bias circuit to apply the above mentioned bias voltages.

In this way, bias voltages can be applied by the bias circuit to the amplifier stage input (e.g. the base terminal of the transistor 30) at a relatively low impedances at the lower frequencies (including, for example, modulation frequencies and DC), whereas for the second frequencies (which, again, may generally correspond to the RF frequencies to be amplified by the amplifier stage), the bias circuit may present relatively high impedances (the "second impedances") to the amplifier stage input. This can allow an appropriate bias to be applied to the amplifier stage input for modulation frequencies and DC, while also avoiding loading the amplifier stage input (e.g. the base terminal of the transistor 30) at the frequencies to be amplified by the amplifier stage.

Accordingly, the transistor 40 may operate to detect the RF amplitude present at the base of the transistor 30 (for $C_2 > 0$, where $C_2$ is the capacitance of the variable reactance component 44). The larger the detected RF amplitude, the lower the base-emitter ($V_{be2}$) bias voltage is at the transistor 40, and therefore the lower the base-emitter (Vbei) bias voltage at the transistor 30 will be (thereby reducing the $I_{c1}$ bias current at the first current terminal (e.g. collector terminal) of the transistor 30 and therefore reducing the RF gain of the transistor 30. This effect can provide the possibility of reducing (correcting for) gain expansion, thereby allowing for an improvement in the linearity of the RF amplification performed by the amplifier stage. The bias voltage drop across the resistor 42 may be approximately zero (assuming that ($I_{b2} \times R$) is small enough, where R is the resistance of the resistor 42 and $I_{b2}$ is the current flowing into the base of the transistor 40).

Further details of the operation of the bias circuit are set out below.

The bias circuit shown in Figure 1 may be used as a current mirror, e.g. for a power amplifier core cell. As such, the transistor 40 may be considered to be a bias replica transistor of the transistor 30 within the current mirror. Through the gyration of the RC time constant (R x ($C_1 + C_{be2}$) (where $C_{be2}$ is the base-emitter capacitance of the transistor 40)), an inductive impedance as a function of frequency is created. The values of R and C may be chosen such that the bias circuit presents a high impedance to the control terminal (e.g. the base) of the transistor 30 at the fundamental RF frequency (i.e. to avoid loading the control terminal (e.g. the base) of the transistor 30) and a relatively low impedance across the modulation bandwidth. This is favorable for low-memory-effect designs.

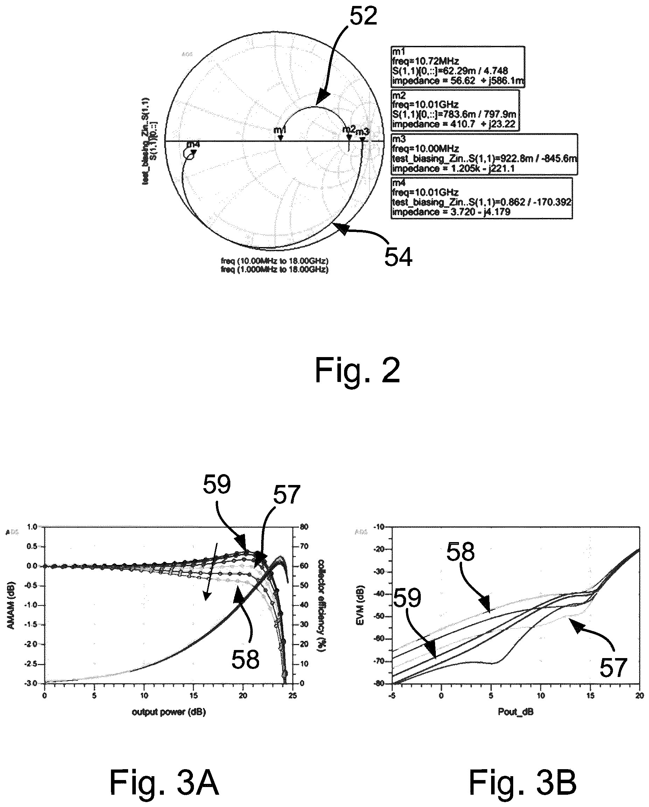

This can be seen from Figure 2, which shows a Smith Chart for the embodiment of Figure 1. The equations below show the derivation of the output impedance of the bias circuit, assuming that the variable reactance component (in this embodiment, the variable capacitor 44 ($C_2$)) is absent. This illustrates the basic operation principle of the bias circuit.

$$Z_{BIAS} = \frac{1 + j\omega RC_1}{gm + j\omega C_1} = r_e \left( \frac{1 + j\omega RC_1}{1 + j\omega r_e C_1} \right)$$

$$\xrightarrow{\omega = 0} Z_{BIAS} \approx r_e = 1/gm$$

$$\xrightarrow{\omega = \infty} Z_{BIAS} \approx R$$

In Figure 2, the plot 52 shows the bias impedance $Z_{BIAS}$ produced by the bias circuit, while the plot 54 shows $Z_{IN,OS}$, namely the impedance looking into the input of the output stage. Figure 2 illustrates that $|Z_{BIAS}|$ << $|Z_{IN,OS}|$ for modulation frequencies and $|Z_{BIAS}|$ >> $|Z_{IN,OS}|$ for RF.

With the introduction of the variable reactance component (e.g. the variable capacitor 44 ($C_2$) in this embodiment), the bias circuit can control the gain compression through the variable capacitor 44 thereby to allow more or less RF swing at the control terminal (e.g. the base) of the transistor 40 as a function of RF drive level.

The introduction of the variable reactance component (e.g. the variable capacitor 44 ($C_2$) in this embodiment) can create a capacitive voltage divider $C_2/(C_1 + C_{be2} + C_2)$ within the bias circuit for controlling how much of the RF signal received at the input 2 is coupled into the control terminal (e.g. the base) of the transistor 40. By allowing more RF swing at the base and through rectification across the base-emitter diode of the transistor 40, the bias base voltage as function of input power can be effectively lowered. This can result in lower $I_{bias}$ vs power, resulting in less gain expansion and effectively a reduction of amplitude-to-amplitude (AM-to-AM) distortion making the amplifier more linear.

Additionally, the capacitive voltage divider can be made programmable through implementing the capacitor $C_1$ and/or the capacitor $C_2$ as a variable capacitor (in the present embodiment, this variable reactance is implemented by the variable capacitor 44 ($C_2$)). This can allow the amount of gain expansion correction to be variable/programmable. This can be a very useful property in an Error Vector Magnitude (EVM) trimming procedure during final test of a product incorporating the analog amplitude pre-distortion circuit 20.

To illustrate these advantages, Figure 3A shows:

- Amplitude-amplitude (AM-to-AM) distortion and collector efficiency vs output power for the embodiment of Figure 1 when sweeping the variable capacitor 44 ($C_2$) from 0fF (plot 59) to 100fF (plot 58), with 60fF (plot 57) as the optimal value; and
- Figure 3B shows Error Vector Magnitude (EVM) vs output power for the embodiment of Figure 1 when sweeping the variable capacitor 44 ($C_2$) from 0fF (plot 59) to 100fF (plot 58), with 60fF (plot 57) as the optimal value.

Thus, Figures 3A and 3B shows the AM-to-AM characteristics when varying the variable capacitor 44 ($C_2$), which may be considered to be an 'RF-ripple control capacitor'. When the capacitance of the variable capacitor 44 ($C_2$) is zero, gain expansion in the AM-to-AM characteristic is observed. At an optimal setting (e.g. 60fF), the AM-to-AM characteristic is nearly flat. However, when overcompensated or too much ripple is allowed at the base of the transistor 40, the AM-to-AM characteristic exhibits gain compression.

In some embodiments, a controller may be provided. The controller may be coupled to the variable reactance component 44 ($C_2$) and may be operable to vary the capacitance of the variable reactance component 44 ($C_2$) as noted above, so as to achieve the desired operation of the bias circuit for applying bias voltages at lower impedances to the amplifier stage input at lower frequencies (e.g. modulation frequencies and/or DC), while presenting higher impedances to the amplifier stage input at the higher frequencies (typically the frequencies to be amplified by the amplifier stage).

In some embodiments, the circuit of Figure 1 may be modified to add a beta helper, so as to provide the bias circuit with a lower-ohmic output. In accordance with these modifications:

- A beta helper may be coupled between the first current terminal of the transistor 40 and the amplifier stage input;
- The resistor 42 may remain directly coupled between the amplifier stage input and the control terminal of the transistor 40 (the same may apply the to the variable reactance component 44);
- The current source 32 may be coupled between a voltage Vdd and the first current terminal of the transistor 40 (as in Figure 1) but may not be coupled to the amplifier stage input (unlike in Figure 1);
- The beta helper may be coupled between the voltage Vdd and the reference potential (e.g. ground), for providing the beta helper with a supply voltage.

As noted above, the beta helper can provide the bias circuit with a lower-ohmic output. In that case, the circuit may be less sensitive for the current gain (beta) of the transistor 30 and for the impedance of the DC-blocking capacitor at the RF input (modulation frequencies).

In some embodiments, an analog amplitude pre-distortion circuit 20 of the kind described herein may be provided within a power amplifier. In some embodiments, an analog amplitude pre-distortion circuit 20 of the kind described herein may be provided within a low-noise amplifier. Amplifiers of this kind may be used in, for example, Wireless Local Area Network (WLAN) front end modules (FEM). Amplifiers of this kind may also be used in, for example, millimeter wave analog beam forming (MMW ABF) applications. Amplifiers of this kind may further be used in, for example, driver and pre-driver applications for base station infrastructure.

In some embodiments, an analog amplitude pre-distortion method is provided. The method includes receiving a Radio Frequency, RF, signal. The method also includes using an amplifier stage to amplify the RF signal to produce an amplified RF signal. The method further includes applying bias voltages to an input of the amplifier stage. This may be achieved by first detecting an amplitude of the RF signal and then (i) applying a bias voltage at a first range of frequencies according to the amplitude of the RF signal at first impedances to the amplifier stage input; and (ii) presenting second impedances at a second range of frequencies to the amplifier stage input. As noted previously, The first impedances are generally lower than the second impedances and the first range of frequencies are generally lower than the second range of frequencies.

Accordingly, there has been described an analog amplitude pre-distortion circuit and method. The circuit includes a Radio Frequency, RF, input for receiving an RF signal. The circuit also includes an amplifier stage comprising an amplifier stage input coupled to the RF input for receiving the RF signal, wherein the amplifier stage is operable to amplify the RF signal to produce an amplified RF signal. The circuit further includes a bias circuit. The bias circuit includes a transistor having a first current terminal, a second current terminal and a control terminal, wherein the first current terminal is coupled to the amplifier stage input (e.g. either directly or via a beta helper as explained above) and wherein the second current terminal is coupled to a reference potential. The bias circuit also includes a resistor coupled between the amplifier stage input and the control terminal. The bias circuit also includes a variable reactance component coupled to the control terminal. The bias circuit further includes a capacitor coupled between the control terminal and the reference potential. The bias circuit is operable to detect an amplitude of the RF signal. The bias circuit is also operable to apply a bias voltage at a first range of frequencies according to the amplitude of the RF signal at first impedances to the amplifier stage input. The bias circuit is further operable to present second impedances at a second range of frequencies to the amplifier stage input. The first impedances are lower than the second impedances and wherein the first range of frequencies are lower than the second range of frequencies.

Although particular embodiments of this disclosure have been described, it will be appreciated that many modifications/additions and/or substitutions may be made within the scope of the claims.

**Claims**

1. An analog amplitude pre-distortion circuit comprising:

   a Radio Frequency, RF, input for receiving an RF signal;
   an amplifier stage comprising an amplifier stage input coupled to the RF input for receiving the RF signal, wherein the amplifier stage is operable to amplify the RF signal to produce an amplified RF signal; and
   a bias circuit comprising:

   a transistor having a first current terminal, a second current terminal and a control terminal, wherein the first current terminal is coupled to the amplifier stage input and wherein the second current terminal is coupled to a reference potential;
   a resistor coupled between the amplifier stage input and the control terminal;
   a variable reactance component coupled to the control terminal; and
   a capacitor coupled between the control terminal and the reference potential,

   wherein the bias circuit is operable to:

   detect an amplitude of the RF signal;
   apply a bias voltage at a first range of frequencies according to the amplitude of the RF signal at first impedances to the amplifier stage input; and
   present second impedances at a second range of frequencies to the amplifier stage input;
   wherein the first impedances are lower than the second impedances and wherein the first range of frequencies are lower than the second range of frequencies.

2. The circuit of claim 1, wherein the variable reactance component comprises a variable capacitor.

3. The circuit of claim 1 or claim 2, further comprising a controller for programmably controlling the variable reactance component.

4. The circuit of any preceding claim, further comprising an output for outputting an amplified RF signal from the amplifier stage.

5. The circuit of any preceding claim, further comprising a current source coupled to the first current terminal.

6. The circuit of any preceding claim, wherein the transistor is a bipolar transistor, wherein the first current terminal is a collector terminal of the bipolar transistor, wherein the second current terminal is an emitter terminal of the bipolar transistor, and wherein the control terminal is a base terminal of the bipolar transistor.

7. The circuit of any preceding claim, wherein the amplifier stage input comprises a control terminal of a transistor.

8. The circuit of any preceding claim, further comprising a DC-blocking capacitor coupled between the RF input and the amplifier stage input.

9. A power amplifier or a low noise amplifier comprising a circuit according to any preceding claim.

10. An analog amplitude pre-distortion method comprising:

receiving a Radio Frequency, RF, signal;
using an amplifier stage to amplify the RF signal to produce an amplified RF signal; and
applying bias voltages to an input of the amplifier stage by:

detecting an amplitude of the RF signal;
applying a bias voltage at a first range of frequencies according to the amplitude of the RF signal at first impedances to the amplifier stage input; and
presenting second impedances at a second range of frequencies to the amplifier stage input;
wherein the first impedances are lower than the second impedances and wherein the first range of frequencies are lower than the second range of frequencies.

11. The method of claim 10, comprising using a bias circuit to apply the bias voltages to the amplifier stage input, wherein the bias circuit comprises:

a transistor having a first current terminal, a second current terminal and a control terminal, wherein the first current terminal is coupled to an amplifier stage input of the amplifier stage and wherein the second current terminal is coupled to a reference potential;
a resistor and a variable reactance component coupled in parallel between the amplifier stage input and the control terminal; and
a capacitor coupled between the control terminal and the reference potential.

12. The method of claim 11, further comprising programmably controlling the variable reactance component to vary the bias voltages applied to the amplifier stage input.

13. The method of claim 11 or claim 12, wherein the variable reactance component is a variable capacitor.

14. The method of any of claims 11 to 13, wherein the transistor is a bipolar transistor, wherein the first current terminal is a collector terminal of the bipolar transistor, wherein the second current terminal is an emitter terminal of the bipolar transistor, and wherein the control terminal is a base terminal of the bipolar transistor.

15. The method any of claims 11 to 14, wherein the amplifier stage input comprises a control terminal of a transistor.

**Amended claims in accordance with Rule 137(2) EPC.**

1. An analog amplitude pre-distortion circuit (20) comprising:

a Radio Frequency, RF, input (2) for receiving an RF signal;
an amplifier stage comprising an amplifier stage input coupled to the RF input for receiving the RF signal, wherein the amplifier stage is operable to amplify the RF signal to produce an amplified RF signal; and
a bias circuit comprising:

a transistor (40) having a first current terminal, a second current terminal and a control terminal, wherein the first current terminal is coupled to the amplifier stage input and wherein the second current terminal is coupled to a reference potential;
a resistor (42) coupled between the amplifier stage input and the control terminal of the transistor;
a variable reactance component comprising a variable capacitor (44) coupled between the amplifier stage input and the control terminal of the transistor;
a controller for programmably controlling the variable reactance component to vary a capacitance of the variable reactance component; and
a capacitor (46) coupled between the control terminal and the reference potential,

wherein the bias circuit is operable to:

detect an amplitude of the RF signal;
apply a bias voltage at a first range of frequencies according to the amplitude of the RF signal at first impedances to the amplifier stage input; and
present second impedances at a second range of frequencies to the amplifier stage input;

wherein the first impedances are lower than the second impedances and wherein the first range of frequencies are lower than the second range of frequencies.

2. The circuit of claim 1, further comprising an output (4) for outputting an amplified RF signal from the amplifier stage.

3. The circuit of claim 1 or claim 2, further comprising a current source (32) coupled to the first current terminal.

4. The circuit of any preceding claim, wherein the transistor is a bipolar transistor, wherein the first current terminal is a collector terminal of the bipolar transistor, wherein the second current terminal is an emitter terminal of the bipolar transistor, and wherein the control terminal is a base terminal of the bipolar transistor.

5. The circuit of any preceding claim, wherein the amplifier stage input comprises a control terminal of a transistor (30).

6. The circuit of any preceding claim, further comprising a DC-blocking capacitor coupled between the RF input and the amplifier stage input.

7. A power amplifier or a low noise amplifier comprising a circuit according to any preceding claim.

8. An analog amplitude pre-distortion method comprising:

     receiving a Radio Frequency, RF, signal; using an amplifier stage to amplify the RF signal to produce an amplified RF signal; and applying bias voltages to an input of the amplifier stage by:

         detecting an amplitude of the RF signal; applying a bias voltage at a first range of frequencies according to the amplitude of the RF signal at first impedances to the amplifier stage input; and presenting second impedances at a second range of frequencies to the amplifier stage input; wherein the first impedances are lower than the second impedances and wherein the first range of frequencies are lower than the second range of frequencies,

     wherein a bias circuit is used to apply the bias voltages to the amplifier stage input, wherein the bias circuit comprises:

         a transistor (40) having a first current terminal, a second current terminal and a control terminal, wherein the first current terminal is coupled to an amplifier stage input of the amplifier stage and wherein the second current terminal is coupled to a reference potential; a resistor (42) and a variable reactance component comprising a variable capacitor (44) coupled in parallel between the amplifier stage input and the control terminal of the transistor; and a capacitor (46) coupled between the control terminal and the reference potential, the method further comprising programmably controlling the variable reactance component to vary a capacitance of the variable reactance component, to vary the bias voltages applied to the amplifier stage input.

9. The method of claim 8, wherein the transistor is a bipolar transistor, wherein the first current terminal is a collector terminal of the bipolar transistor, wherein the second current terminal is an emitter terminal of the bipolar transistor, and wherein the control terminal is a base terminal of the bipolar transistor.

10. The method of claim 8 or claim 9, wherein the amplifier stage input comprises a control terminal of a transistor (30).

Fig. 1

m1
freq=10.72MHz
S(1,1)[0,::]=62.29m / 4.748
impedance = 56.62 + j586.1m

m2
freq=10.01GHz
S(1,1)[0,::]=783.6m / 797.9m
impedance = 410.7 + j23.22

m3
freq=10.00MHz
test_biasing_Zin..S(1,1)=922.8m / -845.6m
impedance = 1.205k - j221.1

m4
freq=10.01GHz
test_biasing_Zin..S(1,1)=0.862 / -170.392
impedance = 3.720 - j4.179

freq (10.00MHz to 18.00GHz)
freq (1.000MHz to 18.00GHz)

## Fig. 2

Fig. 3A

Fig. 3B

Europäisches
Patentamt

European
Patent Office

Office européen
des brevets

**EUROPEAN SEARCH REPORT**

Application Number

EP 22 18 4775

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/006611 A1 (DE JONG GERBEN WILLEM [NL] ET AL) 4 January 2018 (2018-01-04) * paragraph [0084]; figure 5 * | 1-15 | INV. H03F1/02 H03F1/32 H03F1/56 |
| X | US 10 284 148 B2 (NXP BV [NL]) 7 May 2019 (2019-05-07) * column 8 - column 9; figures 5, 6A * | 1-15 | H03F3/195 H03F3/213 H03H11/48 |
| X | US 2018/006021 A1 (BERGERVOET JOZEF REINERUS MARIA [NL] ET AL) 4 January 2018 (2018-01-04) * paragraph [0067] - paragraph [0096]; figures 1-6 * | 1-15 | |
| A | KR 2010 0099873 A (KOREA ELECTRONICS TELECOMM [KR]; IUCF HYU [KR]) 15 September 2010 (2010-09-15) * figures 4, 8, 9 * | 1-15 | |
| A | KR 101 058 641 B1 (SAMSUNG ELECTRO MECH [KR]) 22 August 2011 (2011-08-22) * figures 3, 5 * | 1-15 | TECHNICAL FIELDS SEARCHED (IPC) H03F H03H |

The present search report has been drawn up for all claims

| Place of search | Date of completion of the search | Examiner |
|---|---|---|
| The Hague | 12 December 2022 | Rafflenbeul, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 22 18 4775

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2022

| Patent document cited in search report | | Publication date | Patent family member(s) | | Publication date |
|---|---|---|---|---|---|
| US 2018006611 | A1 | 04-01-2018 | CN | 107565908 A | 09-01-2018 |
| | | | EP | 3264597 A1 | 03-01-2018 |
| | | | US | 2018006611 A1 | 04-01-2018 |
| US 10284148 | B2 | 07-05-2019 | EP | 3346608 A1 | 11-07-2018 |
| | | | US | 2018198420 A1 | 12-07-2018 |
| US 2018006021 | A1 | 04-01-2018 | EP | 3264596 A1 | 03-01-2018 |
| | | | US | 2018006021 A1 | 04-01-2018 |
| KR 20100099873 | A | 15-09-2010 | NONE | | |
| KR 101058641 | B1 | 22-08-2011 | NONE | | |

EPO FORM P0459

For more details about this annex : see Official Journal of the European Patent Office, No. 12/82